(19) Europäisches Patentamt
European Patent Office
Office européen des brevets

(11) Publication number: **0 109 070**
**B1**

(12) **EUROPEAN PATENT SPECIFICATION**

(45) Date of publication of patent specification: **28.01.87**

(51) Int. Cl.[4]: **H 01 L 27/04**

(21) Application number: **83111291.7**

(22) Date of filing: **11.11.83**

# (54) MOS type semiconductor device.

(30) Priority: **11.11.82 JP 198191/82**

(43) Date of publication of application:
**23.05.84 Bulletin 84/21**

(45) Publication of the grant of the patent:
**28.01.87 Bulletin 87/05**

(84) Designated Contracting States:
**DE FR GB IT**

(56) References cited:
**EP-A-0 042 305**
**DE-A-2 559 360**

**Patent Abstracts of Japan Vol. 6, no. 151, 11 August 1982 & JP-A-57-72376**

(73) Proprietor: **Kabushiki Kaisha Toshiba**
**72, Horikawa-cho Saiwai-ku**
**Kawasaki-shi Kanagawa-ken 210 (JP)**

(72) Inventor: **Kinoshita, Hiroyuki**
**75 Yarai-cho Shinjuku-ku**
**Tokyo (JP)**
Inventor: **Ono, Michihiro**
**423 Toshiba-Furukawa-Apartment 87 Furukawa-machi**
**Saiwai-ku Kawasaki-shi (JP)**

(74) Representative: **Lehn, Werner, Dipl.-Ing. et al**
**Hoffmann, Eitle & Partner Patentanwälte**
**Arabellastrasse 4 (Sternhaus)**
**D-8000 München 81 (DE)**

**EP 0 109 070 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a MOS (metal oxide semiconductor) type semiconductor device with a gate protecting circuit for protecting an internal circuit. A MOS type semiconductor device according to the pre-characterising part of claim 1 is for instance known from EP—A—0 042 305.

The MOS type semiconducor device containing a MOS FET (metal oxide semiconductor field effect transistor) has a low withstanding voltage, normally 20 V—100 V, for the reasons that the input impedance of the MOS FET is extremely high and the thickness of the gate insulation film is thin, 40 nm to 100 nm (400 Å to 1000 Å). For this reason, the gate insulation film is easily destroyed by static electricity generated by friction and the like. To protect the gate insulation film from the destruction by the static electricity, the MOS type semiconductor device is provided with a gate film protecting circuit utilizing a forward characteristics or a breakdown characteristics.

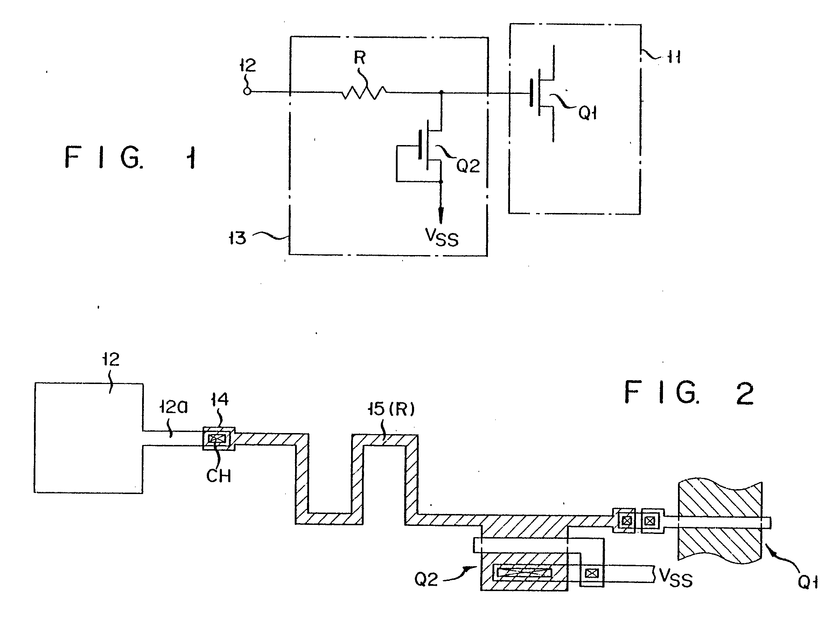

A basic construction of the MOS type semiconductor device with the gate film protecting circuit as it is known from said EP—A—0 042 305 will be described referring to Fig. 1. A MOS FET Q1 constitutes a part of an internal circuit 11. A protecting resistor R made of an impurity diffusion layer is inserted between the gate of the MOS FET Q1 and the input terminal (bonding pad) 12. A protecting MOS FET Q2 is connected between the gate of the MOS FET Q1 and a low potential power source $V_{SS}$. The gate of the MOS FET Q2 is connected to the power source $V_{SS}$. The resistor R and the MOS FET Q2 constitute a protecting circuit 13.

In the circuit thus arranged, when an over-voltage with a sharp pulsative waveform such as surge voltage is applied to the input terminal, the over-voltage passes through the resistor R made of an impurity diffusion layer. The over-voltage is then clamped by the break down or forward characteristics of the PN junction made between the resistor R and the semiconductor substrate and loses a sharpness in the waveform by the resistivity of the resistor R. The high voltage then enters the diffusion layer of the MOS FET Q2 where its amplitude is reduced. The reason for this is that as the low potential power source $V_{SS}$ is applied to the gate electrode of the MOS FET Q2, an electric field strength of the surface of the substrate increases to reduce a breakdown voltage. In this way, the amplitude-reduced voltage is applied to the input section of the internal circuit 11, more exactly the gate of the MOS FET Q1, thereby to protect the internal circuit from the extremely high voltage.

Fig. 2 shows a pattern diagram of the circuit shown in Fig. 1. In Fig. 2, a wiring layer 12a made of aluminum, for example, is for connecting the bonding pad 12 as the input terminal and an impurity diffusion layer 15 constituting a protecting resistive layer R. An imput diffusion layer 14 with a contact hole CH provides a contact of the wiring layer 12a with the resistive layer 15. The resistive layer 15 with resistance of approximtely 500 ohms to several kilo ohms, has a time constant from 1 ns to 5 ns for the over-voltage. With this time constant, the over-voltage is made gentle in the waveform. The state of the art according to the precharacterizing part of claim 1, as well as that in Figures 1 and 2 of the description is known from said document EP—A—0 042 305.

With advances in a microfabrication technique of the integrated circuits, the thickness of the gate insulation film is thinner and the depth of the diffusion layer is shallower. Because of this reduction of the geometries, the gate protecting circuit is easily broken by a relatively small surge voltage. In this respect, the internal circuit is insatisfactorily protected from the over-voltage.

Accordingly, an object of the present invention is to provide a further microfabricated MOS type semiconductor device with a gate protecting circuit which can protect the internal circuit from a large surge voltage with a microfabricated structure.

According to the invention, there is provided a MOS type semiconductor device having a gate protecting circuit having an impurity diffusion layer which includes an input section diffusion layer, and a circuit other than said gate protecting circuit including, at least, a plurality of impurity diffusion layers having therebetween a first distance equal to or larger than a predetermined minimum distance, characterised in that a second distance between said input section layer of said gate protecting circuit and said diffusion layers of said other circuit is determined to have a value ten times or more said predetermined minimum distance.

According to the invention, there is further provided, a MOS type semiconductor device comprising a plurality of gate protecting circuits having impurity diffusion layers which include input section diffusion layers, an internal circuit whose input portions being protected by said gate protecting circuits, the internal circuit including a plurality of impurity diffusion layers having therebetween a first distance equal to or larger than a predetermined minimum distance, characterised in that second distances between said input section layers of said gate protecting circuits and said diffusion layers of said internal circuit are determined to have a value ten times or more said predetermined minimum distance.

An embodiment of the invention can be more fully understood from the following detailed description when taken in conjunction with the accompanying drawings, in which:

Fig. 1 shows a circuit diagram of a basic arrangement of a MOS type semiconductor device with a gate protecting circuit;

Fig. 2 shows a pattern diagram of a conventional MOS type semiconductor device of the circuit of Fig. 1;

Fig. 3 shows a pattern diagram schematically illustrating an embodiment of a MOS type semiconductor device according to the present invention;

Fig. 4 shows an enlarged view of a part of the pattern of Fig. 3;

Fig. 5 shows a pattern diagram illustrating in detail a part of the pattern shown in Figs. 3 and 4;

Fig. 6 shows a cross sectional view of a MOS type semiconductor device containing a diffusion layer of the internal circuit and a gate protecting circuit;

Fig. 7 shows a cross sectional view of a MOS type semiconductor device when two separate internal circuits are interconnected; and

Fig. 8 is a graphical representation of a relationship of a withstanding voltage of the MOS type semiconductor device vs. a distance between the diffusion layers of the internal circuit and the gate protecting circuit.

Many measures have been taken for the destruction problem of the gate protecting circuit. Since a mechanism of the circuit destruction was unknown, however, those measures provided unsatisfactory solutions to this problem. Particularly, no consideration is given on a distance between the diffusion layers of the gate protecting circuit and the internal circuit. Inventors of the present patent application carefully studied and succeeded to make clear this mechanism. The present invention is based on the result of the study.

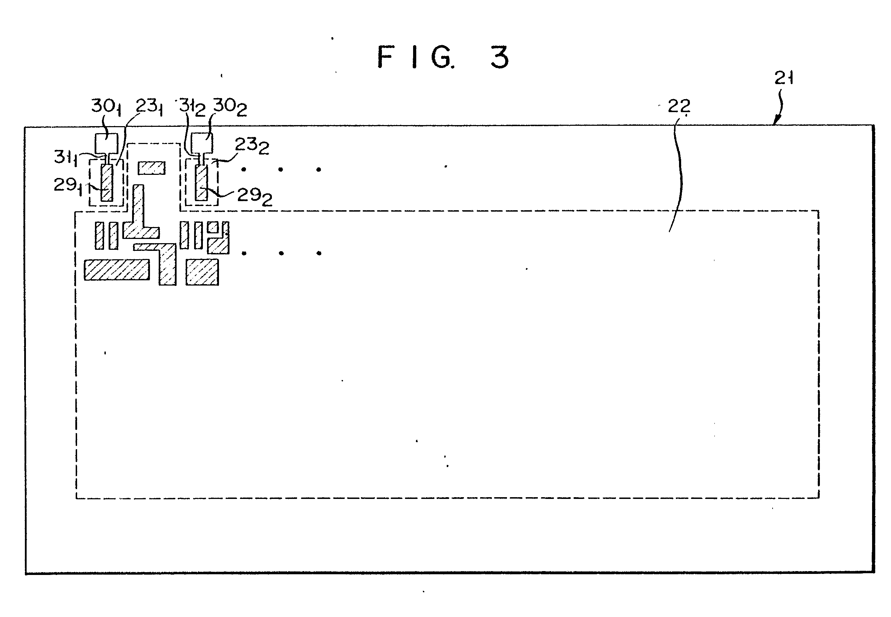

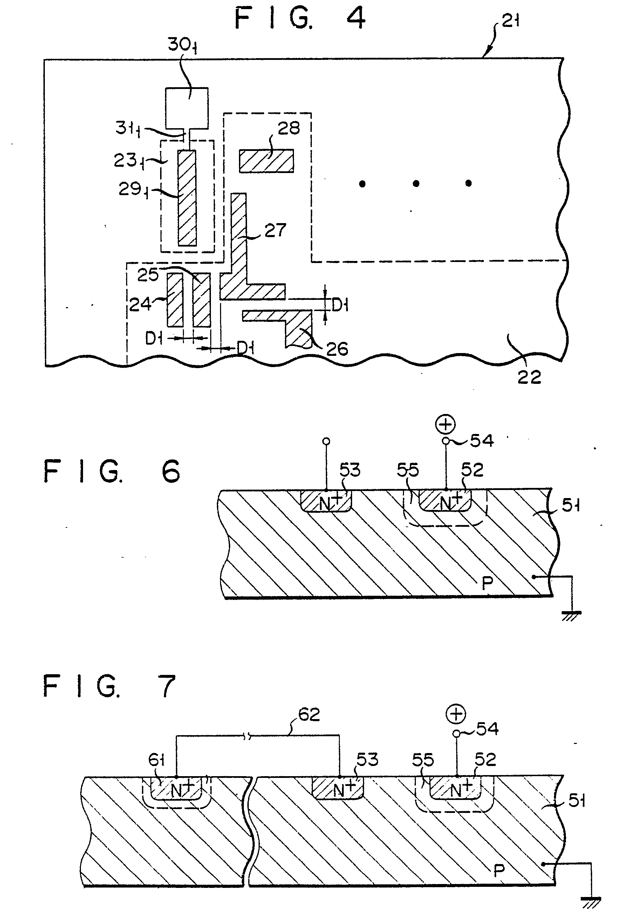

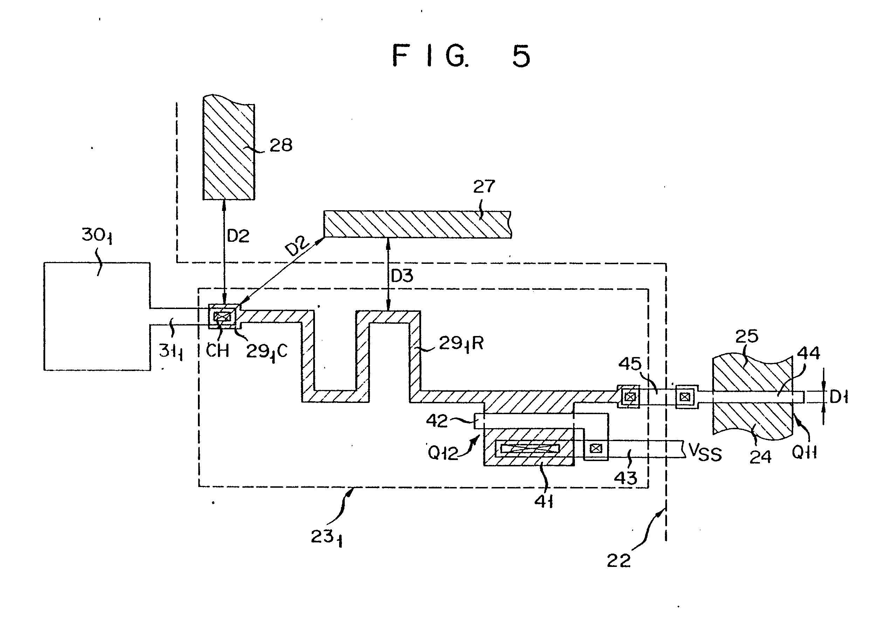

Fig. 3 schematically illustrates a patern of an embodiment of a MOS type semiconductor device according to the present invention. Fig. 4 illustrates the details of an internal circuit 22 and a gate protecting circuit 23, in the pattern shown in Fig. 3. A semiconductor chip 21 bears an internal circuit 22 containing MOS FETs and a plurality of gate protecting circuits $23_1$, $23_2$, . . . formed on the periphery of the internal circuit 22. In Fig. 3, the gate protecting circuits illustrated are only two, for simplicity of illustration. The diffusion layers 24, 25, 27 in the internal circuit 22 are arranged separated from each other by minimum distances D1 as determined from a viewpoint of the microfabrication technique and the circuit design.

The gate protective circuits $23_1$, $23_2$, . . . contain respectively impurity diffusion layers $29_1$, $29_2$, . . . forming protecting resistor etc. The input terminals (bonding pads) $30_1$, $30_2$, . . . are provided on the periphery of the chip 21. The input terminals $30_1$, $30_2$, . . . are connected to gate protecting circuits $23_1$, $23_2$, . . . by means of wiring layers $31_1$, $31_2$, . . . , respectively. Distances from the diffusion layer $29_1$ of the gate protecting circuit $23_1$ to the diffusion layers 24 to 28 of the internal circuit 22 are selected to such values that minority carriers emitted from the diffusion layers 24 to 28 to the semiconductor substrate do not reach a depletion layer of the diffusion layer $29_1$ in the protecting circuit $23_1$, which is caused by a surge voltage applied thereto, and are also selected, though not exactly shown in Figs. 3 and 4, to ten times or more the minimum distances each between the adjacent diffusion layers of those 24 to 28. Though not exactly shown in Figs. 3 and 4, this is correspondingly applied for the distances between the diffusion layer 24 to 28 of the internal circuit 22 and the diffusion layer $29_2$, . . . of other respective gate protecting circuits $23_2$, . . . and applied for the distance between the diffusion layers $29_1$, $29_2$, . . . of adjacent two of the gate protecting circuits $23_1$, $23_2$, . . .

Further details of the patterns of the diffusion layers 24, 25, 27, 28 of the internal circuit 22 and the gate protecting circuit $23_1$ associated therewith are illustrated in Fig. 5.

As shown, the diffusion layer $29_1$ of the gate protecting circuit $23_1$ contains a contact diffusion layer $29_1$C for making the contact with the input section and a diffusion layer $29_1$R as a resistive layer. The contact diffusion layer or input section diffusion layer $29_1$C is connected to the bonding pad $30_1$, through a contact hole CH by way of a wiring layer $31_1$. The gate protecting circuit $23_1$ further contains an impurity diffusion layer 41. A gate electrode 42 made of polysilicon, for example, is formed on the semiconductor chip 21 between the resistive layer $29_1$R and the diffusion layer 41, through a gate insulation film (not shown), for example, an $SiO_2$ film, and a MOS FET Q12 is formed. An electrode layer 43 made of aluminum, for example, is connected to the diffusion layer 41 through a contact hole. The electrodes 42 and 43 are both connected to the power source $V_{SS}$. A gate electrode 44 made of polysilicon, for example, is formed on the semiconductor chip 21 between the diffusion layers 24 and 25 of the internal circuit 22 through a gate insulation film. The diffusion layers 24, 25 and gate electrode 44 constitute an input MOS FET Q11. The resistive diffusion layer $29_1$R of the gate protecting circuit $23_1$ and the gate electrode 44 of the input MOS FET Q11 of the internal circuit 22 are interconnected to each other by a wiring layer 45 made of aluminum, for example, through contact holes.

The mechanism how the gate protecting circuit is destroyed by the incoming surge voltage will be described referring to Fig. 6. In Fig. 6 illustrating a cross section of the MOS type semiconductor device with the gate protecting circuits, a P type silicon subtrate 51 is grounded. Two $N^+$ diffusion regions 52 and 53 with high impurity are formed in the major surface regions of the substrate 51. The region 52 is the diffusion layer (typically, an input section i.e., a connecting diffusion laver to a wiring layer extending from a bonding pad) of the gate protecting circuit. The region 53 is the diffusion layer of the internal circuit or adjacent gate protecting circuit. The region 52 is connected to an input terminal 54.

In operation, when a positive surge voltage is applied to the input terminal 54, the diffusion layer 52 is inversely biased or reverse-biased and destroyed, so that a large current flows into a ground point of the substrate 51. In this case, a substrate potential near the diffusion layer 52 rises via a resistance of the substrate 51. When the diffusion layer 52 in the protecting circuit is located close to the diffusion layer 53 in the internal circuit, the diffusion layer 53 is biased forwardly or forward-biased. Therefore, if the diffusion layer 53 is biased to a fixed potential or its capacitance is large, minority carriers are injected from the diffusion layer 53 into the substrate 51. The minority carriers partially reach the depletion layer 55 where those are accelerated. Since in the depletion layer 55 an intensity of the electric field is high, the minority carriers reaching there receive great energy. The minority carriers with the great energy gained hit the silicon crystal in the substrate 51 to generate electron-hole pairs and hence to multiply the carriers. The result is to increase a breakdown current largely. The break down current causes a great amount of thermal energy to generate at the junction face of the diffusion layer 52, and to destroy the junction face. Therefore, the withstanding voltage is considerably reduced.

Let us consider a case that the diffusion layer 53 of the internal circuit is connected to an diffusion layer 61 in another internal circuit separately located, by means of a conductive layer 62 made of aluminum, for example, which is indicated by a single line in Fig. 7. also in this case, when a positive surge voltage is applied to the input terminal 54, the diffusion layer 52 is inversely biased and destroyed. Then, the potential of that part of the substrate 51 which is near the diffusion layer 52 rises to forwardly bias the diffusion layer 53 in the near internal circuits. In this case, when the capacitance of the diffusion layer 53 is small, the diffusion layer 53 is supplied with the minority carriers from the diffusion layer 61 because the diffusion layer 53 is connected to the diffusion layer 61, unlike the Fig. 6 case. When the potential of the diffusion layer 53 rises, the potential of the diffusion layer 61 rises, too. However, the substrate potential near the diffusion layer 61 is invariable, and then the diffusion layer 61 is destroyed. The result is to supply the minority carriers from the diffusion layer 61 to the diffusion layer 53 and to inject the minority carriers into the silicon substrate 51. The minority carriers partially reach the depletion layer 55 in the diffusion layer 52, to cause the multiplication of the carriers. The multiplied carriers generate a great amount of heat at the junction of the diffusion layer 52. This leads to the reduction of the withstanding voltage.

While this destruction mechanism has been described using the case that the semiconductor device is applied with the positive surge voltage, this mechanism is correspondingly applied to the case where it is applied with a negative surge voltage. In this case, the bias state is opposite to that of the former case. Namely, when a negative surge voltage is applied, the diffusion layer of the internal circuit is reverse-biased and it is destroyed. The constructions of Figs. 6 and 7 are typical because the diffusion layer of the internal circuit is generally connected to a power source or a far located diffusion layer for circuit formation.

As seen from the foregoing description, with only the presence of a diffusion layer disposed close to a diffusion layer applied with a surge voltage, the diffusion layer inversely biased is destroyed, leading to a great reduction of the withstanding voltage. In other words, the withstanding voltage depends largely on a distance between the diffusion layers of the gate protecting circuit and the diffusion layers the internal circuit or adjacent gate protecting circuit. With a further study by us, in the embodiment of Figs. 3 to 5, the distances D2 and D3 between the diffusion layers 24 to 28 in the internal circuit 22 and the diffusion layer $29_1$ of the gate protecting circuit $23_1$ (containing the diffusion layer $29_1$C and the diffusion layer $29_1$R for the protecting resistors) are each set at values at least ten times the minimum distance between the adjacent diffusion layers of those 24 to 28 which are arranged constituting the internal circuit 22. This distance must also be such that it perfectly prevents the minority carriers emitted from the diffusion layers 24 to 28 from reaching the depletion layer of the diffusion layer $29_1$ in the gate protecting circuit $23_1$ which is caused by the impression of the surge voltage. With such a selection of the distances, if the minority carriers are injected from the diffusion layers 24 to 28 into the silicon substrate, majority of the minority carriers are recombined in the silicon substrate, preventing the minority carriers from reaching the gate protecting circuit 23, thereby improving the withstanding voltage greatly. The requirements for the selection of these distances as mentioned above are true for other gate protecting circuits.

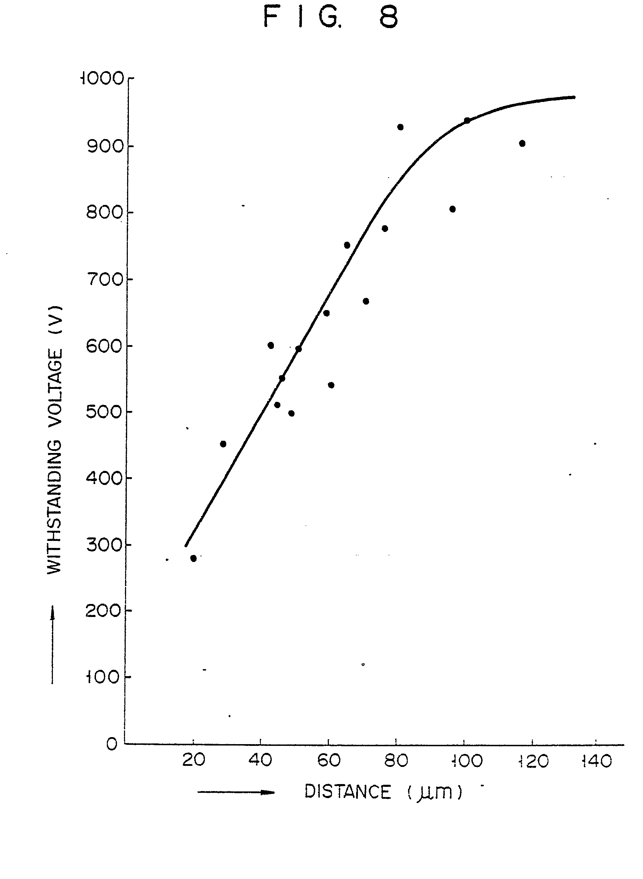

To check how the distances in question influence the withstanding voltage, a variation of the withstanding voltage was measured against the distance between the diffusion layers in the gate protecting circuit and internal circuit. Fig. 8 shows the result of a destruction test carried out using electric charges storaged in a capacitor of 200 pF. On an abscissa is plotted a withstanding voltage or tolerance against electro-static discharge and on an ordinate is plotted a distance (corresponding to D2 shown in Fig. 5) between the input diffusion layer of the gate protecting circuit and the diffusion layer of the internal circuit. The graph of Fig. 8 teaches many facts. The withstanding voltage depends largely on the distance, and its increase is substantially proportional up to about 100 µm of the distance. The value 400 V at the distance 30 µm is satisfactory in practical use. In the range from about 90 µm to 100 µm, the withstanding voltage is approximately 1000 V. As seen from Fig. 8, practically, at least 30 µm is required for the distance, and 150 µm creates no surge problem even if variations in resistivity of a substrate and diffusion length of minority carriers are taken into account, which arise during wafer process. The input section diffusion layer $29_1$C is the region to which a surge voltage is first applied, and therefore, the input section diffusion layer $29_1$C is applied with the voltage higher than that applied to the resistor diffusion layer $29_1$R and has a high current density. Through the resistor diffusion layer $29_1$R is less influenced by the surge voltage than the input section diffusion layer $29_1C$, the resistor diffusion layer $29_1R$ is still influenced by the surge voltage. To avoid this influence, it is necessary to set a distance D3 between the resistor diffusion layer and the diffusion layer of the internal circuit by 20 μm or more.

In the above embodiment, the distances between the diffusion layers of the gate protecting circuits $23_1$, $23_2$, . . . and the diffusion layers in the internal circuit 22 or adjacent gate protecting circuit are substantially equal to each other. The reason for this is that the withstanding voltages in those circuit pairs are set within a narrow range of the variation of the voltages, for the purpose of improving the withstanding voltage of the MOS type semiconductor device as a whole.

It should be understood that the present invention is not limited to the above-mentioned embodiment. For example, any type of the gate protecting circuits can be employed in implementing the present invention, if it has a structure containing the diffusion layer.

As seen from the foregoing description, the present invention has successfully provided a further microfabricated MOS type semiconductor device with a gate protecting circuit having a high withstanding voltage.

**Claims**

1. A MOS type semiconductor device comprising:

a gate protecting circuit ($23_1$) having an impurity diffusion layer ($29_1$) which includes an input section diffusion layer ($29_1C$); and

a circuit ($29_2$, . . . ; 22) other than said gate protecting circuit including, at least, a plurality of impurity diffusion layers (24, 25, 27) having therebetween a first distance equal to or larger than a predetermined minimum distance (D1);

characterized in that: a second distance (D2) between said input section layer ($29_1C$) of said gate protecting circuit and said diffusion layers of said other circuit is determined to have a value ten times or more said predetermined minimum distance.

2. A MOS type semiconductor device according to claim 1, characterized in that said second distance (D2) is determined such that minority carriers emitted from said diffusion layer of one of said circuits do not reach a depletion layer of said diffusion layer of the other of said circuits, and the depletion layer occurs when a surge voltage is applied.

3. A MOS type semiconductor device according to claims 1 or 2 characterized in that said other circuit includes an internal circuit (22) whose input section (44) is protected by said gate protecting circuit.

4. A MOS type semiconductor device according to claims 1 or 2 characterized in that said other circuit includes one or more gate protecting circuits ($29_2$, . . .).

5. A MOS type semiconductor device according to any one of claims 1 to 4 characterized in that said second distance (D2) between said input section layer and the diffusion layers in said other circuits is 30 μm or more.

6. A MOS type semiconductor device according to any one of claims 1 to 4 characterized in that said second distance (D2) between said input section layer and the diffusion layers in said other circuit is 150 μm or less.

7. A MOS type semiconductor device according to any one of claims 1 to 4 characterized in that said impurity diffusion layer ($29_1$) in said gate protecting circuit is composed of said input section layer ($29_1C$) and a resistive element layer ($29_1R$), and a third distance (D3) between said resistive element layer and the diffusion layers in said other circuit is 20 μm or more.

8. A MOS type semiconductor device according to any one of claims 1 to 4 characterized in that said impurity diffusion layer ($29_1$) in said gate protecting circuit is composed of said input section layer ($29_1C$) and a resistive element layer ($29_1R$), and a third distance (D3) between said resistive element layer and the diffusion layers in said other circuit is 150 μm or less.

9. A MOS type semiconductor device comprising:

a plurality of gate protecting circuits ($23_1$, $23_2$, . . .) having impurity diffusion layers ($29_1$, $29_2$, . . .) which include input section diffusion layers; and an internal circuit (22) whose input portions (44) being protected by said gate protecting circuits, the internal circuit including a plurality of input diffusion layers (24, 25, 27) having therebetween a first distance equal to or larger than a predetermined minimum distance (D1);

characterized in that: second distances (D2) between said input section layers of said gate protecting circuits and said diffusion layers of said internal circuit are determined to have a value ten times or more said predetermined minimum distance.

10. A MOS type semiconductor device according to claim 9 characterized in that said distances (D2) are determined such that minority carriers emitted from said diffusion layers of one of said internal circuit and gate protecting circuits do not reach a depletion layer of said diffusion layers of the other of said internal circuit and gate protecting circuits, and the depletion layer occurs when a surge voltage is applied.

11. A MOS type semiconductor device according to claim 9, characterized in that said second distances (D2) are substantially equal to each other.

12. A MOS type semiconductor device according to claims 9, 10 or 11 characterized in that distances between said diffusion layers of adjacent two of said gate protecting circuits are substantially equal to said second distances (D2).

13. A MOS type semiconductor device according to any one of claims 9 to 12 characterized in that said second distances are 30 μm or more.

14. A MOS type semiconductor device according to any one of claims 9 to 12 characterized in that said second distances are 150 μm or less.

**Patentansprüche**

1. MOS-Halbleiterbauelement mit einem Gatterschutzkreis ($23_1$) mit einer Störstellendiffusionsschicht ($29_1$), welche eine Eingangsabschnittdiffusionsschicht ($29_1$C) enthält; und

einem Kreis ($29_2$; ...; 22), der ein anderer als der Gatterschutzkreis ist, enthaltend mindestens eine Vielzahl von Störstellendiffusionsschichten (24, 25, 27), mit einem ersten Abstand dazwischen gleich oder größer als ein verbestimmter Minimalabstand (D1);

dadurch gekennzeichnet, daß ein zweiter Abstand (D2) zwischen der Eingangsabschnittschicht ($29_1$C) des Gatterschutzkreises und den Diffusionsschichten des anderen Kreises mit einem Wert zehnfach oder mehr des vorbestimmten Minimalabstandes bestimmt ist.

2. MOS-Halbleiterbauelement nach Anspruch 1, dadurch gekennzeichnet, daß der zweite Abstand (D2) derart bestimmt ist, daß aus der Diffusionsschicht eines der Kreise emittierte Minoritätsträger eine Verarmgungsschicht der Diffusionsschicht des anderen der Kreise nicht erreichen, und die Verarmungsschicht beim Anlegen eines Stoßspannung auftritt.

3. MOS-Halbleiterbauelement nach Anspruch 1 oder 2, dadurch gekennzeichnet, daß der andere Kreis einen inneren Stromkreis (22) enthält, dessen Eingangsabschnitt (44) durch den Gatterschutzkreis geschützt ist.

4. MOS-Halbleiterbauelement nach Anspruch 1 oder 2, dadurch gekennzeichnet, daß der andere Kreis einen oder mehrere Gatterschutzkreis ($29_2$, ...) enthält.

5. MOS-Halbleiterbauelement nach einem der Ansprüche 1 bis 4, dadurch gekennzeichnet, daß der zweite Abstand (D2) zwischen der Eingangsabschnittsschicht und den Diffusionsschichten in den anderen Kreisen 30 µm oder mehr ist.

6. MOS-Halbleiterbauelement nach einem der Ansprüche 1 bis 4, dadurch gekennzeichnet, daß der zweite Abstand (D2) zwischen der Eingangsabschnittsschicht und den Diffusionsschichten in dem anderen Kreis 150 µm oder weniger ist.

7. MOS-Halbleiterbauelement nach einem der Ansprüche 1 bis 4, dadurch gekennzeichnet, daß die Störstellendiffusionsschicht ($29_1$) in dem Gatterschutzkreis aus einer Eingangsabschnittsschicht ($29_1$C) und einer Widerstandselementschicht ($29_1$R) besteht, und ein dritter Abstand (D3) zwischen der Widerstandselementschicht und den Diffusionsschichten in dem anderen Kreis 20 µm oder mehr ist.

8. MOS-Halbleiterbauelement nach einem der Ansprüche 1 bis 4, dadurch gekennzeichnet, daß die Störstellendiffusionsschicht ($29_1$) in dem Gatterschutzkreis aus einer eingangsabschnittsschicht ($29_2$C) und einer Widerstandselementschicht ($29_1$R) besteht, und ein dritter Abstand (D3) zwischen der Widerstandselementschicht und den Diffusionsschichten in dem anderen Kreis 150 µm oder weniger ist.

9. MOS-Halbleiterbauelement mit einer Vielzahl von Gatterschutzkreisen ($23_1$, $23_2$, ...) mit Störstellendiffusionsschichten ($29_1$, $29_2$, ...), welche Eingangsabschnittsdiffusionsschichten enthalten; und

einem inneren Kreis (22), dessen Eingangsabschnitte (44) durch die Gatterschutzkreise geschützt sind, wobei der innere Kreis eine Vielzahl von Eingangsdiffusionsschichten (24, 25, 27) mit einem ersten Abstand dazwischen gleich oder größer als ein vorbestimmter Minimalabstand (D1) enthält;

dadurch gekennzeichnet, daß zweite Abstände (D2) zwischen den Eingangsabschnittsschichten der Gatterschutzkreise und den Diffusionsschichten des inneren kreises mit einem Wert zehnfach oder mehr des vorbestimmten Minimalabstandes bestimmt sind.

10. MOS-Halbleiterbauelement nach Anspruch 9, dadurch gekennzeichnet, daß die Abstände (D2) derart bestimmt sind, daß die aus den Diffusionsschichten eines des inneren Kreises und der Gatterschutzkreise emittierten Minoritätsträger eine Verarmungsschicht der Diffusionsschichten des anderen des inneren Kreises und der Gatterschutzkreise nicht erreichen, und die Verarmungsschicht beim Anlegen einer Stoßspannung auftritt.

11. MOS-Halbleiterbauelement nach Anspruch 9, dadurch gekennzeichnet, daß die zweiten Abstände im wesentlichen einander gleich sind.

12. MOS-Halbleiterbauelement nach einem der Ansprüche 9, 10 oder 11, dadurch gekennzeichnet, daß die Abstände zwischen den Diffusionsschichten von zwei nebeneinander liegenden der Gatterschutzkreise im wesentlichen gleich den zweiten Abständen (D2) sind.

13. MOS-Halbleiterbauelement nach einem der Ansprüche 9 bis 12, dadurch gekennzeichnet, daß die zweiten Abstände 30 µm oder mehr sind.

14. MOS-Halbleiterbauelement nach einem der Ansprüche 9 bis 12, dadurch gekennzeichnet, daß die zweiten Abstände 150 µm oder weniger sind.

**Revendications**

1. Dispositif semiconducteur du type MOS comprenant:

un circuit de protection de grille ($23_1$) comprenant une couche de diffusion d'impuretés ($29_1$) qui comprend une couche de diffusion de partie d'entrée ($29_1$C); et

un circuit ($29_2$, ... ; 22) autre que le circuit de protection de grille comprenant au moins une pluralité de couches de diffusion d'impuretés (24, 25, 27) espacées entre elles d'une première distance supérieure ou égale à une distance minimale prédéterminée (D1);

caractérisé en ce qu'une seconde distance (D2) entre la couche de partie d'entrée ($29_1$C) du circuit de protection de grille et les couches de diffusion dudit autre circuit est déterminée pour avoir une valeur égale à dix fois ou plus ladite distance minimale prédéterminée.

2. Dispositif semiconducteur du type MOS selon la revendication 1, caractérisé en ce que la seconde distance (D2) est déterminée de sorte que des porteurs minoritaires émis à partir de ladite couche de diffusion de l'un desdits circuits n'atteignent pas une couche déplétive de la couche de diffusion de l'autre desdits circuits, et en ce que la couche déplétive apparaît quand une surtension est appliquée.

3. Dispositif semiconducteur du type MOS selon l'une des revendications 1 ou 2, caractérisé en ce que ledit autre circuit comprend un circuit interne (22) dont la partie d'entrée (44) est protégée par ledit circuit de protection de grille.

4. Dispositif semiconducteur du type MOS selon l'une des revendications 1 ou 2, caractérisé en ce que ledit autre circuit comprend un ou plusieurs circuits de protection de grille ($29_2$, . . .).

5. Dispositif semiconducteur du type MOS selon l'une quelconque des revendications 1 à 4, caractérisé en ce que la seconde distance (D2) entre la couche de partie d'entrée et des couches de diffusion dans lesdits autres circuits est de 30 µm ou plus.

6. Dispositif semiconducteur du type MOS selon l'une quelconque des revendications 1 à 4, caractérisé en ce que la seconde distance (D2) entre la couche de partie d'entrée et les couches de diffusion dans ledit autre circuit est de 150 µm ou moins.

7. Dispositif semiconducteur du type MOS selon l'une quelconque des revendications 1 à 4, caractérisé en ce que la couche de diffusion d'impuretés ($29_1$) dans le circuit de protection de grille est composée de ladite couche de partie d'entrée ($29_1$C) et d'une couche d'élément résistif ($29_1$R) et en ce qu'une troisième distance (D3) entre la couche d'élément résistif et les couches de diffusion dans ledit autre circuit est de 20 µm ou plus.

8. Dispositif semiconducteur du type MOS selon l'une quelconque des revendications 1 à 4, caractérisé en ce que ladite couche de diffusion d'impuretés ($29_1$) dans ledit circuit de protection de grille est composée de ladite couche de partie d'entrée ($29_1$C) et d'une couche d'élément résistif ($29_1$R), et en ce qu'une troisième distance (D3) entre ladite couche d'élément résistif et les couches de diffusion dans ledit autre circuit est de 150 µm ou moins.

9. Dispositif semiconducteur du type MOS comprenant:

une pluralité de circuits de protection de grille ($23_1$, $23_2$, . . .) comprenant des couches de diffusion d'impuretés ($29_1$, $29_2$, . . .) qui comprennent des couches de diffusion de partie d'entrée; et un circuit interne (22) dont les parties d'entrée (44) sont protégées par les circuits de protection de grille, le circuit interne comprenant une pluralité de couches de diffusion d'entrée (24, 25, 27) ayant entre elles une première distance supérieure ou égale à une distance minimale prédéterminée (D1);

caractérisé en ce que des secondes distances (D2) entre les couches de parties d'entrée des circuits de protection de grille et les couches de diffusion du circuit interne sont déterminées pour avoir une valeur égale à dix fois la distance minimale prédéterminée ou plus.

10. Dispositif semiconducteur du type MOS selon la revendication 9, caractérisé en ce que lesdites distances (D2) sont déterminées de sorte que les porteurs minoritaires émis à partir desdites couches de diffusion de l'un desdits circuit interne et circuit de protection de grille n'atteignent pas une couche déplétive des couches de diffusion de l'autre desdits circuit interne et circuits de protection de grille, et en ce que la couche déplétive apparaît quand une surtension est appliquée.

11. Dispositif semiconducteur du type MOS selon la revendication 9, caractérisé en ce que lesdites secondes distances (D2) sont sensiblement égales les unes aux autres.

12. Dispositif semiconducteur du type MOS selon l'une des revendications 9, 10 ou 11 caractérisé en ce que les distances entre les couches de diffusion de deux adjacents desdits circuits de protection de grille sont sensiblement égales auxdits secondes distances (D2).

13. Dispositif semiconducteur du type MOS selon l'une quelconque des revendications 9 à 12, caractérisé en ce que lesdites secondes distances sont de 30 µm ou plus.

14. Dispositif semiconducteur du type MOS selon l'une quelconque des revendications 9 à 12, caractérisé en ce que lesdites secondes distances sont de 150 µm ou plus.

11
Q1
Q2
VSS
R
12
13
F I G. 1
F I G. 2
Q1
VSS
Q2
15 (R)
14
CH
12a
12

FIG. 3
21
22
23₂
29₂
30₂
31₂
23₁
30₁
31₁
29₁

F I G. 4
21
30₁
31₁
23₁
29₁
28
27
25
24
D1
D1
D1
26
22

F I G. 6
⊕
54
53
55
52
N+
N+
51
P

F I G. 7
62
⊕
54
61
53
55
52
N+
N+
N+
51
P

D1
44
Q11
25
24
VSS
45
43
22
41
27
42
Q12
29₁R
D3
23₁
28
D2
29₁C
CH
31₁
30₁

F I G. 5

FIG. 8

1000
900
800
700
600
500
400
300
200
100
0
WITHSTANDING VOLTAGE (V)
20
40
60
80
100
120
140
DISTANCE (μm)